# EUROPEAN PATENT APPLICATION

(11) **EP 2 924 145 A1**
(43) Date of publication of application: **30.09.2015**
(21) Application number: 13884368.5
(22) Date of filing: 22.10.2013
(51) Int. Cl.: C23F 13/02

(54) **CORROSION PROTECTION STATION USING PULSE CURRENT**

(30) Priority: 23.11.2012 RU 2012149995
(71) Applicant: Sulimin, Yuriy Vladimirovich, Moskovskaya ob., g. Lyubertsy, 140006 (RU)
(72) Inventor: SULIMIN, Yuriy Vladimirovich, Moskovskaya obl., g. Lyubertsy, 140006 (RU); PETUKHOV, Victor Sergeevich, Leninskiy r-n, Moskovskaya obl., 142791 (RU); SULIMINA, Elena Yurievna, Moskovskaya obl., g. Lyubertsy, 140003 (RU)
(74) Representative: Spengler, Robert
(86) International application number: PCT/RU2013/000937
(87) International publication number: WO 2014/081339

(57) **Abstract**

Corrosion protection station using pulse current for metal structures, which comprises direct-current sources connected by switches either to the structure to be protected, or to an anode, and means for measuring the output current. A high capacity storage capacitor is connected in parallel with the output of each direct-current source, said high capacity storage capacitor providing an output current which is higher than the charging current of said capacitor. A high-power FET is used as a switch via which the current pulses are supplied to a load. A high-current diode is installed between said transistor and an output terminal, said high-current diode separating the external load from the pulse circuit. A surge protection device is connected in parallel with the output terminals of the pulse circuit, said surge protection device protecting the corrosion protection station using pulse current from lightning discharges in the vicinity of the structures to be protected, the anodic ground connection and the supply lines. An additional surge protection device is installed at the input of the corrosion protection station using pulse current to protect it from surges in the AC mains and from lightning discharges in the vicinity of AC supply lines. The technical result ensures an increased reliability of the device during protection of extended facilities against corrosion.

## Description

### Technical field

Corrosion protection station using pulse current belongs to corrosion protection equipment and designed to protect extending objects from corrosion, as buried under the ground and also located on the holders of gas pipelines, oil pipelines and oil-products pipelines, oil tanks and others tanks, ferroconcrete substructure and others engineering constructions, which have contact with the ground.

### Preceding technical level

Widely used at present time corrosion protection stations are powered by AC system (alternating current system) 380/220V, 50 Hz frequency and output adjustable constant current (see, for example, patent RU N°2953432, In. Cl. C23F 13/00 from 22.06.1995. However, in some cases it is impossible to protect the above-listed objects by direct current: strange metal structures, rivers and streams (including underground) shielding the whole areas of objects to be protected from the current flowing out the anodic bed. Therefore, to extend the coverage of cathodic protection of extended object to these areas, it is necessary to apply the high voltage and current from the cathodic protection station. In case the DC protection near the point of connection station to the protecting object (the point of drain) hydrogen is released, which penetrate in the pipe metal and gradually it become fragility. Hydrogen evolution also brings to tearing away protective coating, thereby reducing its repair interval. Above-ground pipelines cannot be protected by DC. Pulse method of corrosion protection (see patent RU N°2172087, In. Cl. F16L 58/00 from 20.01.2000) is eliminate of these disadvantages.

One of the first devices was pulsed cathodic protection device of boats (see USA patent N°3242064, In. Cl. S23F 13/00 from 22.03.1966). However, such device could not protect extended objects from corrosion.
In the invention of American investigator T. Doniguian (see patent USA N°5324405, In. Cl. C23F 13/00 from 28.06.1994) it was proposed a method and a system of pulsed cathodic protection station by short (5-100mcs) highfrequency pulses (1-5kHz) of iron metal structures such as pipelines and well casing located in a conducting medium. However, the high pulse frequency, applied to the system, decrease the protection area and the high voltage make this method inapplicable to oil and gas pipelines for safety reasons, which limits the scope applicability of this method.

The closest technical solution to the proposed corrosion protection station using pulse current is pulse current cathodic protection system of American inventor Thaddeus Doniguian (see USA patent RE38581, C23F 13/00 from 14.09.2004). In this system is used a device consisting of one or more sources of direct current (according to the number of separately protected structures), which power pulse current sources connected directly to the protected structures and to one anodic assemble, common for all protected structures. All sources of pulsed current are operated by the same control circuit, thereby providing synchronization of all sources of pulsed current. The control circuit can be adjusted frequency and pulse duration at own discretion. The current value of each current pulse source can also be adjusted at own discretion, depending on the dimension and distance to the protected structure. Control of the output current carries special device, which is a part of the of the DC stabilization circuit. The control circuit can adjust the pulse duration from 5 to 10 mcs and average current value - up to 15 A. However, the system of cathodic protection of extended structures at high frequencies (several kHz) has a high inductive resistance, which is proportional to the square of the frequency, so the pulse current sources for the protection of extended structures must output a high voltage (100-300 V), which is unacceptable for pipelines, transporting flammable substances (gas, gas condensate, crude oil, petroleum products). Thus, a high voltage used in the high frequency pulsed current sources limits their field of application.

### Disclosure of the invention

In order to eliminate the above-mentioned disadvantages in pulse current cathodic protection station of metal constructions, containing one or more DC sources connected to one or more of pulse current sources connected to a separate structures or to anode beds by switches, which are bipolar transistors with insulated gates that are connected to the control circuit of frequency and a pulse current duration, it is proposed to use infra-low frequencies 0,07-0,18 Hz and pulse duration not less than 1 sec, in order to the storage condenser of high capacity is connected in parallel to the output of each DC power source, for providing an output pulse current exceeding to many times the charging current of this condenser, and as the switch via which pulse current supplied to a load, high-power field transistor is applied, to prevent excess voltage in pulse current source, for example, due to thunderstorms or stray current, high-current diode separating the load and pulse circuit is set between this transistor and output terminal. It is installed at the output of pulse device control circuit which used, for example, an output LED indicator. LED indicator can be further to added by others control devices, generally forming recipient devices to control supply of the pulse current the protected structure. At the output of each pulse current source lightning discharges protection are set, protecting also the pulse current corrosion protection station from applying currents in pipelines, anode beds or cables connecting them with corrosion protection station using pulse current. Also at the input of the corrosion protection station using pulse current the overvoltage surge protection device in the AC mains is set, simultaneously serving as a protection from lightning discharges in the vicinity of AC supply lines and applying currents from lightning discharges.

### Brief description of drawing view

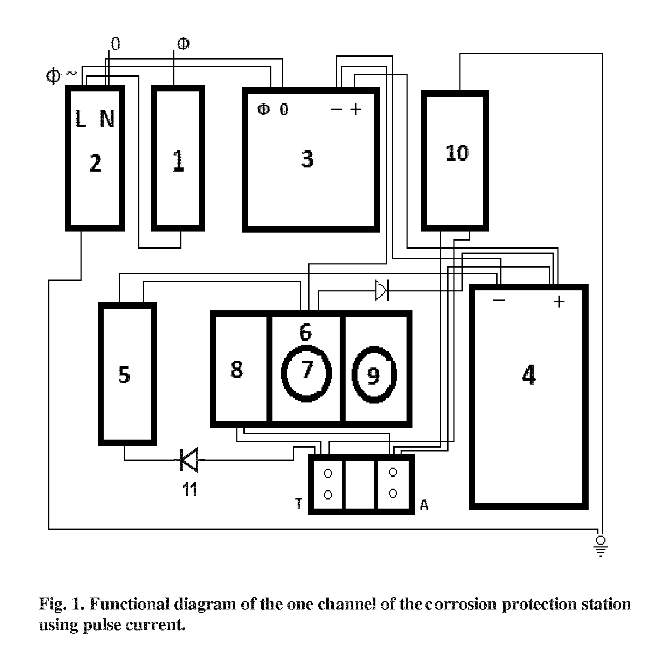

The functional diagram of the one channel of the corrosion protection station using pulse current is represented on the fig.1.

### Preferred embodiment

Corrosion protection station using pulse current, which functional diagram is presented on fig. 1, is one of the optimal versions of the invention implementation. Taking into account previous experience of exploitation of station of cathodic corrosion protection, which broke down mainly because of thunderstorms and overvoltages in supply mains, so a lot of attention is paid to the lightning discharge protection in the proposed version. Apart from the established input automation 1 the overvoltage surge protection device in the AC main 2 is installed, which is operated simultaneously as lightning discharges protection. The outputs of each channel of station of cathodic corrosion protection by pulse current are also protected by special device 10 from strikes of lightning in protected structures and anodic bed, as well as interference in the wires and stray currents. The transformerless stabilized power supply with limiting output current is the most suitable as the DC power source 3, because it is designed for charging the high-capacity storage condenser. If this condenser is discharged, the DC power supply will operated almost on short-circuit load. Under these exploitation conditions the power supply of other type immediately fails. The use of high-capacity storage condenser 4 is necessary in view of the need to obtain quite lengthy (over 1 s) current pulses of up to 100 A. The use of molecular energy accumulator (ionistor) as a high-capacity storage condenser 4 allowed rejecting the use of heavy and bulky transformer power supplies. If necessary the molecular energy accumulators allow to outpute pulse currents of up to 400 A and more, which are needed, for example, by the protection of marine underwater crossings. Transistor switch 5, via which the high-capacity storage condenser is partially discharging to the load, operates in saturation mode, so even at the high current the voltage drop across it is small and, therefore, it is released very little power, so a small radiator can be used for cooling the transistor. Transistor switches 5 of one or more pulse current sources are controlled by one control circuit, which is represented as a rectangle pulses master generator 6 executed from a microcontroller and a few transistors. Only the one regulator is accessible to the operator - pulse repetition frequency regulator 7. According to the practice, there is no need for operative adjustment of the pulse duration: at the slow frequencies a charge has time to spread evenly across the surface of the protected structures in the intervals between pulses. If necessary, the pulse duration as well as frequency pulse repetition rate can be changed by the programmer or the computer. Adjusting the pulse amplitude is carried out by diode-resistive block, which is not included in the corrosion protection station using pulse current, and which is set separately for each protected structure, although technically such adjustment can be accomplished by setting linear amplification mode for each output transistor and to change the amplitude of the output pulses by means of potentiometer. But in that case the sizes of radiators would be increased many times and, the most important, this technical solution would reduce the reliability of the device. At high pulse duration control of the operation of each channel of corrosion protection station using pulse current may be carried out by a simple LED 8. The switch of operating mode 9 allows to charging separately the high-capacity storage condenser 4 while the pulse master generator 6 is switched off, to disable charging of the high-capacity storage condenser 4 and the pulse master generator 6, to switch on charging of the high-capacity storage condenser 4 and simultaneously the pulse master generator 6. High-current diode 11 protects the high-power field transistor 5 from self-induced electromotive force arising when the current is interrupted at the extended metal structures and from stray currents.

### Industrial applicability

The most rational is to apply the proposed model of corrosion protection station using pulse current at the sites of gas pumping compressor stations, booster pump stations of oil pipelines, urban communications, ferroconcrete foundations of houses, sports facilities and other metal objects with large number of pipelines, shielding each other from the protective current cathodic protection stations by direct current. While protecting these objects by pulse current due to the effect of spreading, the charge given to a metallic structure distributes evenly over its surface even on those areas that were inaccessible during the protection by direct current.

## Claims

1. The corrosion protection station using pulse current for metal structures, which comprises at least one or more DC sources, which are connected to the appropriate protected structures or to anode beds by switches which are used a bipolar transistors with isolated gates and which are connected to the circuit of control frequency and duration of the pulse current, output current measuring instrument, wherein the corrosion protection station using pulse current is differed by connection of high-capacity storage condensers in parallel to an outputs each DC power sources said high-capacity storage condenser providing an output current, which is higher than the charging current of said condenser, a high-power field transistors are used as switches via which the current pulses are supplied to a load, wherein a high-current diodes are installed between said transistors and output terminals, said high-current diodes separates the external load from pulse circuits, said an overvoltage surge protecting devices are connected in parallel to output terminals of the pulse circuits and protects the corrosion protection station using pulse cunent from lightning discharges in the vicinity structures to be protected, an anodic beds and connecting wires, the additional overvoltage surge protecting device is installed at the input of the corrosion protection station using pulse current, to protect it from voltage surges in AC mains and from lightning discharges in the vicinity of AC supply lines.
